# EUROPEAN PATENT SPECIFICATION

(11) **EP 3 368 984 B1**
(45) Date of publication and mention of the grant of the patent: **20.10.2021**
(21) Application number: 16860481.7
(22) Date of filing: 30.09.2016
(51) Int. Cl.: G06F 11/10, H03M 13/35, H03M 13/15

(54) **TEMPERATURE DEPENDENT MULTIPLE MODE ERROR CORRECTION**
TEMPERATURABHÄNGIGE MULTIMODALE FEHLERKORREKTUR
CORRECTION D'ERREUR DE MODES MULTIPLES DÉPENDANT DE LA TEMPÉRATURE

(30) Priority: 30.10.2015 US 201514929163
(43) Date of publication of application: 05.09.2018
(73) Proprietor: INTEL Corporation, Santa Clara, CA 95054 (US)
(72) Inventor: WU, Wei, Portland, Oregon 97229 (US); AUGUSTINE, Charles, Hillsboro, Oregon 97124 (US); TOMISHIMA, Shigeki, Portland, Oregon 97229 (US); LU, Shih-Lien L., Portland, Oregon 97229 (US); TSCHANZ, James W., Portland, Oregon 97229 (US)
(74) Representative: Rummler, Felix
(86) International application number: PCT/US2016/055033
(87) International publication number: WO 2017/074648

(56) References cited:
- WO-A1-2015/048023
- US-A1- 2012 144 270
- US-A1- 2013 318 418
- US-A1- 2013 318 418
- US-A1- 2014 047 305
- US-A1- 2014 181 614
- US-A1- 2015 261 602
- US-A1- 2015 302 924
- WOOJIN YUN ET AL: "Thermal-aware energy minimization of 3D-stacked L3 cache with error rate limitation", PROC. 2011 IEEE INTERNATIONAL SYMPOSIUM ON CIRCUITS AND SYSTEMS (ISCAS), IEEE, 15 May 2011 (2011-05-15), pages 1672-1675, XP031997963, DOI: 10.1109/ISCAS.2011.5937902 ISBN: 978-1-4244-9473-6

## Description

### TECHNICAL FIELD

Certain embodiments of the present description relate generally to devices such as memory employing error correction.

### BACKGROUND

In the course of reading data from a memory, errors may be encountered such that the data read from memory may not match the original data stored in memory. Similarly, as data is written to the memory, errors may be introduced such that the data stored in memory may not match the original data intended to be written. Also, data may become corrupted while stored in a memory.

Various techniques are frequently employed for purposes of detecting such errors and correcting them if possible. For example, a memory controller may have Error Correction (or Correcting) Code (ECC) encoder logic for purposes of encoding the data before it is written into the memory cells of the memory. Such encoding frequently includes adding redundant data such as check bits, for example, to the original write data. The encoded data when subsequently read from the memory, may be decoded by a decoder of the ECC logic of the memory controller to restore the original write data if errors are detected. The ECC decoder logic can frequently detect errors which may have occurred in transmission to or from the memory or while the data was stored in memory, and correcting them if not too severe. Generally, the more redundant data added to the write data by the ECC encoder logic, the more robust the error detection and correcting capabilities of the ECC decoder logic of the memory controller. For example, by adding additional check bits to the encoded data, the number of errors which may be detected and corrected may be increased.

A memory typically has an associated Raw Bit Error Rate (RBER). Thus, the error correction scheme selected for a memory has typically been devised to provide an error detection and correction capability at a sufficiently high level to bring the
error rate down to an acceptable level. For example, in some applications, an error rate of less than one error per 100,000 bits (often expressed as "1E-6") may be acceptable.

There are various known ECC techniques for detecting and correcting data errors including for example, block codes such as Reed-Solomon error correction codes, for example, which process data on a block-by-block basis, and convolutional codes , for example, which process data on a bit-by-bit basis. In some applications such as deep space transmission of data between Earth and space probes, and compact disk recording and playback devices, for example, it is known to encode data twice using two different ECC schemes which are concatenated together as an outer ECC scheme and an inner ECC scheme, to operate in sequence on the data. By concatenating the ECC techniques, error detection and correction can be enhanced in some applications, as compared to employing just one of the ECC techniques alone.
D1 discloses a storage subsystem comprising a non-volatile storage with a controller and an error-correction module. The controller selects the quantity of ECC data to be generated based on one or several quantities, which can be the temperature. The quantity of ECC data is generally proportional to the error probability.
D2 discloses a resistance change memory comprising a memory cell array, an ECC circuit, and a controller. The ECC refresh operations are performed at intervals depending on the temperature of the memory cell array.
D3 discloses a method of choosing the number of parity bits according to the number of errors detected by a previous reading and error-correcting operation using a first (fast-read) technique of error correction.
D4 discloses a method to minimize the energy consumption of a memory system consisting of a DRAM memory cell array, a controller, and an ECC circuit. The method consists in using a higher number of parity bits at higher temperature, in order to avoid increasing the refresh rate.

### BRIEF DESCRIPTION OF THE DRAWINGS

Embodiments of the present disclosure are illustrated by way of example, and not by way of limitation, in the figures of the accompanying drawings in which like reference numerals refer to similar elements.
FIG. 1 depicts a high-level block diagram illustrating selected aspects of a system, employing temperature dependent, multiple mode error correction in accordance with an embodiment of the present disclosure.
FIGs. 2a, 2b depict examples of basic architectures of a memory and memory controller, employing temperature dependent, multiple mode error correction in accordance with an embodiment of the present disclosure.
FIGs 3a-3e provide examples of operations for temperature dependent, multiple mode error correction in accordance with an embodiment of the present disclosure.
FIGs. 4a-4c illustrate in greater detail an example of an architecture of a memory and memory controller, employing temperature dependent, multiple mode error correction in accordance with an embodiment of the present disclosure.
FIGs. 5a-5c illustrate examples of various formats of data storage in a memory employing temperature dependent, multiple mode error correction in accordance with an embodiment of the present disclosure.

### DESCRIPTION OF EMBODIMENTS

The present invention relates to an apparatus as defined in claim 1, and to a method as defined in independent claim 8.

In the description that follows, like components have been given the same reference numerals, regardless of whether they are shown in different embodiments. To illustrate an embodiment of the present disclosure in a clear and concise manner, the drawings may not necessarily be to scale and certain features may be shown in somewhat schematic form. Features that are described and/or illustrated with respect to one embodiment may be used in the same way or in a similar way in one or more other embodiments and/or in combination with or instead of the features of the other embodiments.

Temperature dependent, multiple mode error correction in accordance with one aspect of this disclosure, is employed for a memory circuit containing arrays of memory cells. In one aspect, it is believed that temperature dependent, multiple mode error correction in accordance with the present disclosure can reduce power consumption of the memory in one or more modes of operation. It is appreciated that other aspects and advantages may be achieved, depending upon the particular application.

In one embodiment, a temperature sensor coupled to an array is configured to provide an output signal which is a function of the temperature of the array of memory cells. Multiple mode error correction code (ECC) logic having an input coupled to an output of the temperature sensor, is configured to encode write data for the array of memory cells in an error correction code in one of a plurality of error correction modes as a function of the temperature of the array of memory cells.

For example, ECC encoder logic in accordance with one embodiment, includes a first mode ECC encoder logic and a second mode ECC encoder logic. The first mode ECC encoder logic, that is, a high temperature mode (HTM) ECC encoder logic in one example, encodes write data at a first ECC level which is a relatively high ECC level to provide a relatively high degree of error detection and correction for higher temperature operating levels of the memory at which higher RBER is expected. In one embodiment, the HTM encoder logic encodes write data in a relatively long ECC code word encoding to achieve the relatively high degree of error detection and correction for higher temperature operating levels of the memory. An example of a relatively high degree of error detection and correction is a double detection, double correction scheme capable of both detecting and correcting double errors in encoded data. Other examples of suitable high temperature error correction include five bit error correction. Still other examples include seven bit error correction which is believed to be able to lower the error rate to as low as 1E-9 at 100 degrees Celsius. It is appreciated that the level of error correction in the various temperature modes may vary, depending upon the particular application.

Conversely, the second mode ECC encoder logic, that is, a low temperature mode (LTM) ECC encoder logic in one example, encodes write data at a second ECC level which is a relatively low ECC level to provide a relatively lower degree of error detection and correction for lower level operating temperatures of the memory at which lower RBER is expected. In one embodiment, the LTM ECC encoder logic encodes write data in a relatively short ECC code word encoding to achieve the relatively lower degree of error detection and correction for lower level operating temperatures of the memory. An example of a relatively low degree of error detection and correction is a double detection, single correction scheme capable of detecting double errors but correcting only single errors in encoded data. It is believed that power consumption of the memory may be reduced when operating in a lower level ECC correction mode such as the LTM mode, for example at which lower RBER is expected.

In another aspect, ECC decoder logic in accordance with one embodiment, includes a first mode ECC decoder logic and a second mode ECC decoder logic. The first mode ECC decoder logic, that is, a high temperature mode (HTM) ECC decoder logic in one example, is configured to decode read data from the memory which was encoded in a relatively long ECC code word encoding in the relatively high ECC level to provide a relatively high degree of error detection and correction for higher temperature operating levels of the memory at which higher RBER is expected. Similarly, the second mode ECC decoder logic, that is, a low temperature mode (LTM) ECC decoder logic in one example, is configured to decode read data from the memory which was encoded in a relatively short ECC code word encoding in the relatively low ECC level to provide a relatively lower degree of error detection and correction for lower temperature operating levels of the memory at which higher RBER is expected. It is believed that power consumption may be reduced at lower operating temperatures by utilizing the LTM ECC decoder logic to decode read data encoded in the relatively short ECC code word.

In still another aspect, the ECC encoder logic is configured to set an encoder status flag to indicate whether the write data associated with the encoder status flag was encoded in a relatively long ECC code word encoding in the relatively high ECC level or was encoded in a relatively short ECC word encoding at the second error correction level lower than the first error correction level. The encoder status flag may be used, in one embodiment, to facilitate a transition from one mode to another such as, for example, from the low temperature mode (LTM) to the high temperature mode (HTM).

For example, the temperature dependent, multiple mode ECC logic may be further configured to enter the first high temperature ECC mode in response to a temperature sensor output signal indicating that the temperature of the array of memory cells has risen to a temperature level that exceeds a threshold level, and to detect whether the encoder status flag has been set for a line of write data. If so, the multiple mode ECC logic may re-encode write data at the first error correction level in a relatively long ECC code word encoding in response to a detection of the encoder status flag being set for the associated write data, indicating that the write data had previously been encoded at the second error correction level in a relatively short ECC code word encoding. Upon completion of this transition to the high temperature (HTM) ECC mode, write data may be encoded and read data decoded at the first error correction level in the high temperature (HTM) ECC mode at which higher RBER is expected.

In still another aspect, the ECC encoder is logic is configured to set a decoder status flag to indicate whether the read data associated with the decoder status flag may be decoded using the relatively long ECC code word decoding in the relatively high ECC level or may be decoded using the relatively short ECC code word decoding at the second error correction level lower than the first error correction level. The decoder status flag may be used, in one embodiment, to facilitate a transition from one mode to another such as, for example, from the high temperature mode (HTM) to the low temperature mode (LTM).

For example, the multiple mode ECC logic may be further configured to enter the second error correction mode (LTM) in response to the temperature sensor output signal indicating that the temperature level of the array of memory cells has fallen below a threshold level, and to detect whether the decoder status flag has been set for read data to indicate that the read data associated with the decoder status flag may be decoded using the relatively short ECC code word decoding in the relatively low ECC level. If so, the multiple mode ECC logic may read and decode write data at the second error correction level in response to a detection of the decode status flag being set for the associated read data to indicate that the read data may be decoded at the second error correction level in the LTM ECC mode.

Alternatively, if the multiple mode ECC logic detects that the decoder status flag has been set to indicate that the read data associated with the decoder status flag may be decoded using the relatively long ECC code word decoding in the relatively high ECC level, the multiple mode ECC logic reads and decodes the write data at the first error correction level in response to a detection of the decode status flag being set for the associated read data to indicate that the read data may not be decoded at the second error correction level, and resets the decode status flag to indicate that the read data may subsequently be decoded at the second error correction level.

Although certain embodiments are described herein in connection with two temperature dependent modes, it is appreciated that temperature dependent, multiple mode error correction may be applied to embodiments having more than two temperature modes. For example, a low temperature mode may have a relatively low level of error correction for low temperature operation, such as double error detection and single error correction, for example. An intermediate temperature mode may have a relatively higher level of error correction, such as five bit error correction for an intermediate temperature range such as 60-100 degrees C. A third and higher temperature mode may have a still higher level of error correction such as seven bit error correction, for example, for a still higher temperature range in excess of 100 degrees Celsius, for example. Encoding and decoding operations are conducted in accordance with the applicable level of the error correction capability of the associated temperature dependent mode. It is appreciated that a greater or fewer number of temperature modes may be utilized in temperature dependent, multiple mode error correction in accordance with the present description, depending upon the particular application.

It is believed that temperature dependent, multiple mode error correction in accordance with one aspect of this disclosure may be applied to systems employing a variety of types of memory devices including non-volatile memory such as spin torque transfer (STT) Random Access Memory (RAM), three dimensional (3D) crosspoint, phase change memory, magnetic RAM, a resistive memory, nanowire memory, ferro-electric transistor random access memory (FeTRAM), flash memory such as NAND or NOR, and volatile memory such as 2D RAM, for example. Other types of memory may be suitable as well. Temperature dependent, multiple mode error correction in accordance with embodiments described herein may be used either in stand-alone memory controllers and memory circuits or logic arrays, or can be embedded in microprocessors, digital signal processors (DSPs) or other circuits transmitting or receiving data. Additionally, it is noted that although systems and processes are described herein primarily with reference to microprocessor based systems in the illustrative examples, it will be appreciated that in view of the disclosure herein, certain aspects, architectures, and principles of the disclosure are equally applicable to other types of devices, memory and logic devices.

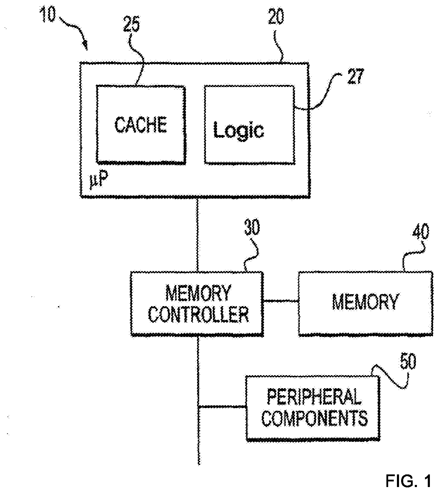

Turning to the figures, FIG. 1 is a high-level block diagram illustrating selected aspects of a system implementing temperature dependent, multiple mode error correction according to an embodiment of the present disclosure. System 10 may represent any of a number of electronic and/or computing devices, that may include a memory device. Such electronic and/or computing devices may include computing devices such as a mainframe, server, personal computer, workstation, telephony device, network appliance, virtualization device, storage controller, portable or mobile devices (e.g., laptops, netbooks, tablet computers, personal digital assistant (PDAs), portable media players, portable gaming devices, digital cameras, mobile phones, smartphones, feature phones, etc.) or component (e.g. system on a chip, processor, bridge, memory controller, memory, etc.). In alternative embodiments, system 10 may include more elements, fewer elements, and/or different elements. Moreover, although system 10 may be depicted as comprising separate elements, it will be appreciated that such elements may be integrated on to one platform, such as systems on a chip (SoCs). In the illustrative example, system 10 comprises a microprocessor 20, a memory controller 30, a memory 40 and peripheral components 50 which may include, for example, video controller, input device, output device, storage, network adapter, etc.. The microprocessor 20 includes a cache 25 that may be part of a memory hierarchy to store instructions and data, and the system memory 40 may also be part of the memory hierarchy. Communication between the microprocessor 20 and the memory 40 may be facilitated by the memory controller (or chipset) 30, which may also facilitate in communicating with the peripheral components 50.

Storage of the peripheral components 50 may be, for example, non-volatile storage, such as STT RAM, solid-state drives, magnetic disk drives, optical disk drives, a tape drive, flash memory, etc. The storage may comprise an internal storage device or an attached or network accessible storage. The microprocessor 20 is configured to write data in and read data from the memory 40. Programs in the storage are loaded into the memory and executed by the processor. A network controller or adapter enables communication with a network, such as an Ethernet, a Fiber Channel Arbitrated Loop, etc. Further, the architecture may, in certain embodiments, include a video controller configured to render information on a display monitor, where the video controller may be embodied on a video card or integrated on integrated circuit components mounted on a motherboard or other substrate. An input device is used to provide user input to the processor, and may include a keyboard, mouse, pen-stylus, microphone, touch sensitive display screen, input pins, sockets, or any other activation or input mechanism known in the art. An output device is capable of rendering information transmitted from the processor, or other component, such as a display monitor, printer, storage, output pins, sockets, etc. The network adapter may embodied on a network card, such as a Peripheral Component Interconnect (PCI) card, PCI-express, or some other I/O card, or on integrated circuit components mounted on a motherboard or other substrate.

One or more of the components of the device 10 may be omitted, depending upon the particular application. For example, a network router may lack a video controller, for example. Any one or more of the memory devices 25, 40, and the other devices 10, 30, 50 may include temperature dependent, multiple mode error correction in accordance with the present description.

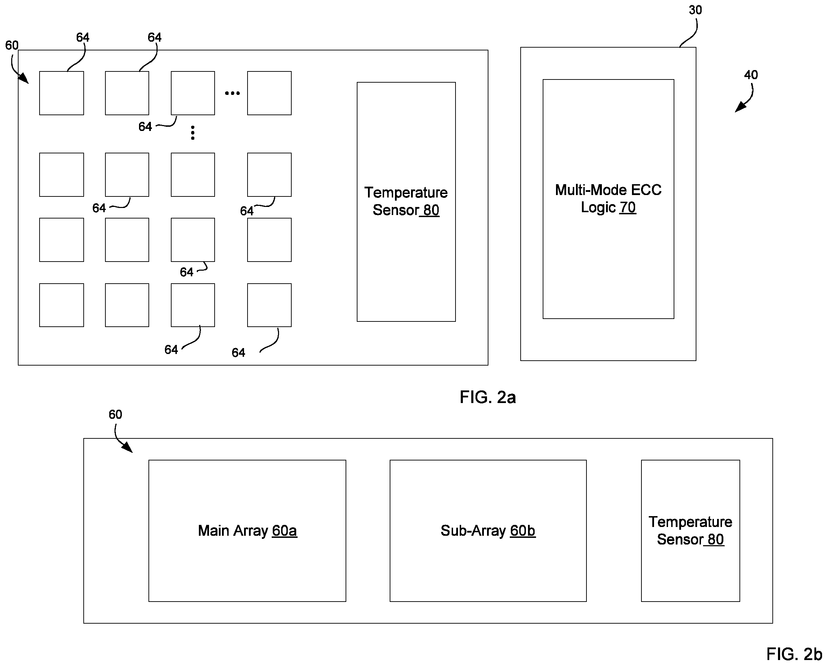

FIG. 2a shows an example of an array 60 of rows and columns of bitcells or memory cells 64 of an STT RAM memory circuit 40 in accordance with one embodiment of the present description. In another embodiment, the memory circuit may be a volatile memory such as a DRAM memory, for example. It is appreciated that the memory circuit 40 may be other types of memory as well.

In the embodiment of FIG. 2a, the memory 40 is a cache memory such as the cache 25 (FIG. 1). It is appreciated that temperature dependent, multiple mode error correction in accordance with the present description may be applied to other types of memory, depending upon the particular application.

Each memory cell 64 is capable of storing a bit of data representing a logical one or logical zero value. The memory controller 30 performs read operations and write operations to the memory cells 64. The STT RAM memory circuit 40 may also include a row decoder, a timer device and I/O devices (or I/O outputs). Bits of the same memory word may be separated from each other for efficient I/O design. Thus, the array 60 of memory cells 64 may be subdivided, either logically or physically into a main array 60a and one or more subarrays 60b of memory cells as shown in FIG. 2b.

A multiplexer (MUX) may be used to connect each column to the required circuitry during a READ operation. Another MUX may be used to connect each column to a write driver during a WRITE operation.

As explained in greater detail below, the memory of this embodiment, includes multiple mode error correction code (ECC) logic 70 which may be disposed on the same integrated circuit as that of the array 60 or may be disposed on other integrated circuits such as the memory controller 40 or may be distributed over more than one integrated circuit. In this embodiment, a temperature sensor 80 is disposed on the same integrated circuit as the array 60 to sense the temperature of the array 60 of memory cells. However, it is appreciated that in other embodiments, the temperature sensor 80 may be disposed on other integrated circuit but positioned in a suitable manner to be thermally coupled to the array 60 to facilitate sensing the temperature of the array 60.

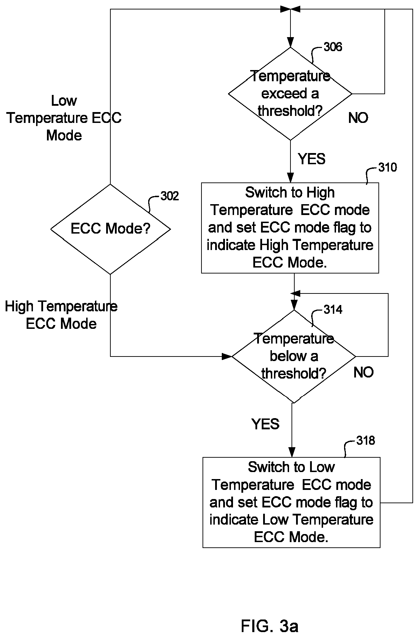

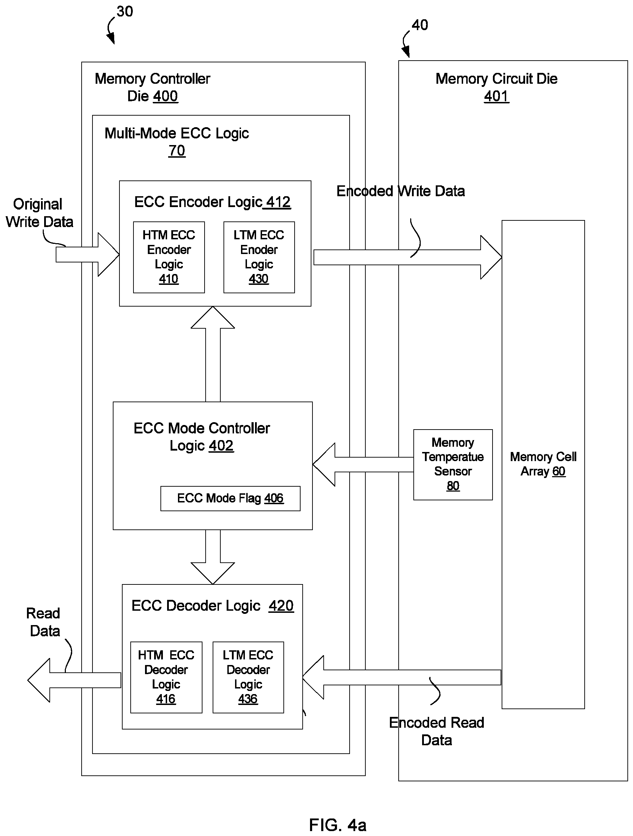

The multiple mode ECC logic 70 is configured to perform described operations using appropriate hardware, software or firmware, or various combinations thereof. FIGs. 3a-3e depict examples of temperature dependent, multiple mode error correction memory operations in accordance with one aspect the present description. FIG. 3a is directed to mode switching operations of temperature dependent, multiple mode error correction logic such as the multiple mode ECC logic 70 depicted in greater detail in FIG. 4a. In the embodiment of FIG. 4a, the ECC logic is disposed on an integrated circuit die 400 on which the memory controller 40 is disposed. It is appreciated that in other embodiments, the ECC logic 70 may be disposed on an integrated circuit die 401 of the memory circuit 40 or on both dies 400, 401 or on other dies, depending upon the particular application.

In one operation, an ECC mode controller logic such as the ECC mode controller logic 402 (FIG. 4a) of the multiple mode ECC logic 70 determines (block 302, FIG. 3a) the current operating mode of the multiple mode ECC logic 70. In one embodiment, the ECC mode controller logic 402 maintains an ECC mode flag 406 (FIG. 4a) which indicates whether the multiple mode ECC logic 70 is operating in a high temperature mode (HTM) or a low temperature mode (LTM). If the ECC mode flag 406 indicates that the multiple mode ECC logic 70 is operating in a low temperature mode (LTM), for example, a determination (block 306, FIG. 3a) is made as to whether the temperature of the memory array being monitored, such as the memory array 60, has exceeded a threshold. In this embodiment, the ECC mode controller logic 402 has an input coupled to an output of the memory temperature sensor 80 which is thermally coupled to the memory array 60 to monitor the temperature of the memory. In one example, the temperature threshold of the determination 306 may be a predetermined value or may be defined by a user input, for example. One such temperature threshold may be a value of 60 degrees Celsius, for example, or may be within a range of 55-65 degrees, for example. It is appreciated that the particular value of the temperature threshold of the determine 306 may vary, depending upon the particular application.

If it is determined (block 306) that the temperature of the memory array 60 being monitored has not exceeded the threshold, the ECC mode controller logic 402 (FIG. 4a) of the multiple mode ECC logic 70 continues to operate in the low temperature ECC mode and to monitor the memory temperature and compare it to a threshold. If it is determined (block 306) that the temperature of the memory array 60 being monitored has exceeded the threshold, the ECC mode controller logic 402 (FIG. 4a) of the multiple mode ECC logic 70 switches (block 310) the mode of operation of the multiple mode ECC logic 70 to the high temperature ECC mode and sets the ECC mode flag 406 to indicate that the multiple mode ECC logic 70 is operating in a high temperature mode (HTM). As explained in greater detail below, in the high temperature ECC mode, write data to be stored in the memory array is encoded in a relatively long ECC code word encoding to provide a relatively high ECC level for a more robust error detection and correction capability at the higher temperatures in which the RBER may increase.

In the high temperature ECC mode, a determination (block 314, FIG. 3a) is made as to whether the temperature of the memory array being monitored, such as the memory array 60, has dropped below a threshold. In one example, the temperature threshold of the determination 314 may be the same as the threshold of the determination of block 306. In another example, the threshold of the determination of block 314 may be displaced somewhat from the threshold of the determination of block 306. Such a displacement such as 5 degrees Celsius, for example, between thresholds may, in some applications, reduce mode switching due to small fluctuations in the temperature of the memory array. Thus, if the threshold for a high temperature mode to low temperature mode transition is set for 60 degrees Celsius, for example, a threshold for a low temperature mode to high temperature mode transition may be set at a displaced value such as 55 degrees Celsius, for example.

Also, as explained in greater detail below, in some embodiments, some processing tasks may be undertaken to prepare for a transition to another mode. As such, a displacement in thresholds may facilitate completing such preparations prior to reaching temperatures which may significantly increase RBER, for example. The temperature threshold of the determination of block 314 may be a predetermined value or may be defined by a user input, for example. It is appreciated that the particular value of the temperature threshold of the determine 314 may vary, depending upon the particular application.

If it is determined (block 314) that the temperature of the memory array 60 being monitored has not dropped below the applicable threshold, the ECC mode controller logic 402 (FIG. 4a) of the multiple mode ECC logic 70 continues to operate in the high temperature ECC mode and to monitor the memory temperature and compare it to a threshold. If it is determined (block 314) that the temperature of the memory array 60 being monitored has dropped below the threshold, the ECC mode controller logic 402 (FIG. 4a) of the multiple mode ECC logic 70 switches (block 318) the mode of operation of the multiple mode ECC logic 70 to the low temperature ECC mode and sets the ECC mode flag 406 to indicate that the multiple mode ECC logic 70 is operating in a low temperature mode (LTM). As explained in greater detail below, in the low temperature ECC mode, write data to be stored in the memory array is encoded in a relatively short ECC code word encoding to provide a relatively low ECC level which provides a somewhat less robust error detection and correction capability at the lower temperatures in which the RBER may be smaller. As a consequence, power consumption may decrease accordingly.

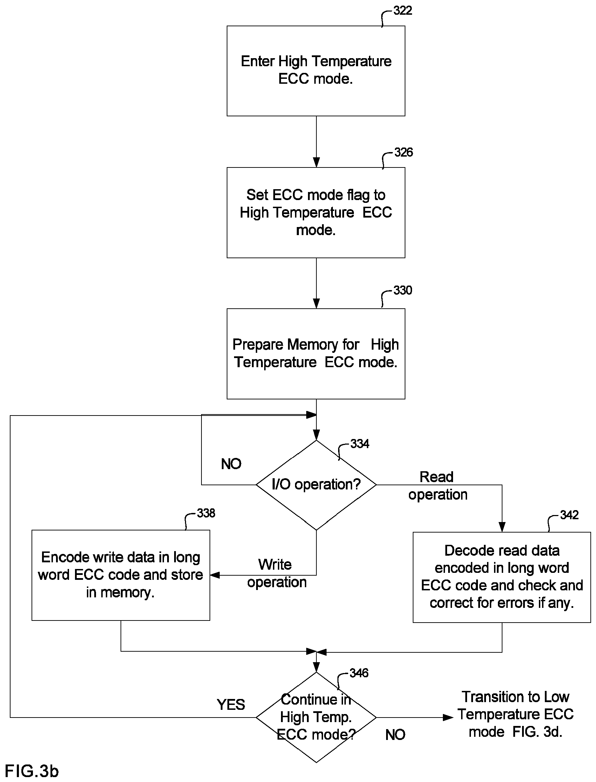

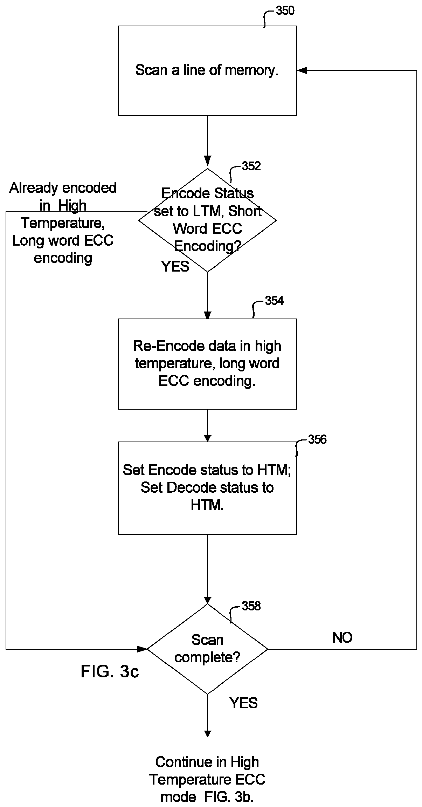

FIG. 3b is directed to operations of the multiple mode ECC logic 70 in a high temperature ECC mode. In connection with entering (block 322, FIG. 3b) the high temperature ECC mode, the ECC mode controller logic 402 (FIG. 4a) of the multiple mode ECC logic 70 sets (block 326) the ECC mode flag 406 to indicate that the multiple mode ECC logic 70 will be operating in the high temperature ECC mode. In accordance with a transition from a low temperature ECC mode to a high temperature ECC mode, preparations (block 330) may be undertaken for the high temperature ECC mode. As explained in greater detail below in connection with Fig. 3c, in one embodiment, such preparations may include scanning the memory array 60 to determine if there are lines of memory which were previously encoded in accordance with a low temperature ECC mode prior to the multiple mode ECC logic entering the high temperature ECC mode. If so, those lines of memory which were encoded in accordance with the low temperature ECC mode may be re-encoded in accordance with the high temperature mode so as to better withstand the higher RBER expected in high temperature operation of the memory.

Upon completion of the preparation of the memory for the high temperature operations, memory I/O operations (block 334) may be processed in a high temperature ECC mode. For example, a memory controller such as the memory controller 30 (FIG. 4a) may receive write data to be written to a memory such as the memory circuit 40. Before the write data is written to the memory, the write data is encoded (block 338) in a relatively long ECC code word encoding by high temperature mode (HTM) ECC encoder logic 410 (FIG. 4a) of an ECC Encoder Logic 412 of the multiple mode ECC Logic 70. Encoding the write data in a relatively long ECC code word encoding provides a relatively high ECC level of error detection and correction capability to compensate for the relatively higher RBER expected during high temperature memory operations.

One example of a suitable error correction code is a Reed-Solomon error correction code which is a block code which encodes blocks of data in symbols to facilitate error detection and correction. It is appreciated that other types of error correction codes may be employed in multiple mode error correction in accordance with the present description. For example, it is believed that both block and convolutional codes may be suitable as a long code for multiple mode error correction in accordance with the present description. Also, it is believed that both systematic and nonsystematic codes may be suitable as a long code for multiple mode error correction in accordance with the present description. In a systematic scheme, an encoder attaches to the original write data a number of check bits (such as parity data, for example), which are derived from the data bits by an appropriate deterministic algorithm. In a system that uses a non-systematic code, the original message is transformed into an encoded message that typically has at least as many bits as the original message. Additional examples of codes which may be suitable as long codes are concatenated codes, recursive codes, non-recursive codes, repetition codes, Hamming codes, multidimensional parity-check codes, turbo codes, low-density parity-check codes (LDPC), etc. The high temperature mode (HTM) ECC encoder logic 410 is configured to encode write data for the memory circuit in a long word error correction code (such as a Reed-Solomon error correction code, for example) encoding of the temperature dependent, multiple mode error correction in accordance with one embodiment of the present description.

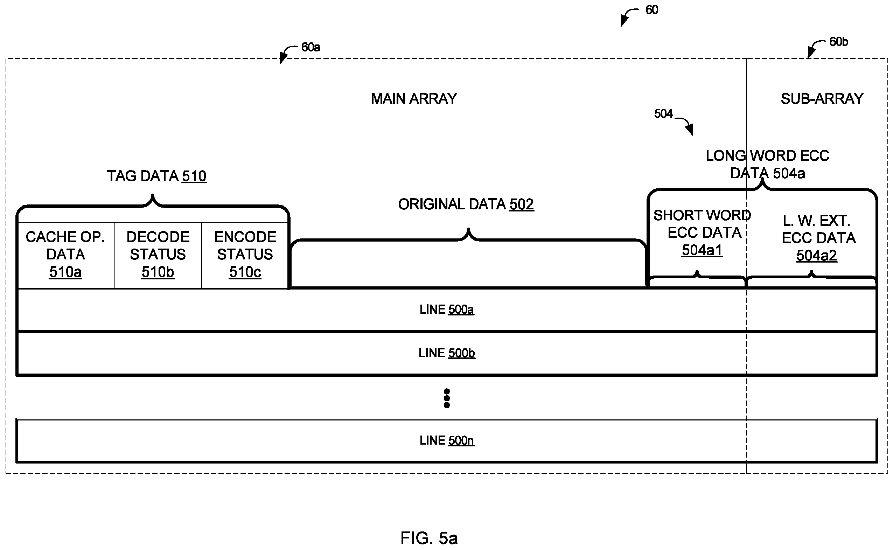

In one embodiment, the high temperature mode (HTM) ECC encoder logic 410 encodes the write data in a long error correction code word encoding which adds redundant data such as check bits for example. Examples of redundant check bit data which may be added for purposes of error detection and correction include parity bits, repetition codes, checksums and cyclic redundancy checks (CRCs). The write data encoded with the long error correction code word encoding may be stored in a memory such as the memory array 60 (FIG. 5a). As explained in greater detail below, the write data encoded in the long error correction code word encoding may subsequently be decoded and checked for errors. In many cases, depending upon the severity of the detected errors, the decoded data may be corrected and restored to its original error-free form before it was written to the memory.

In the illustrated embodiment of FIG. 5a, the memory array 60 is divided either logically or physically, into a main array 60a and a sub-array 60b such that each line of data 500a, 500b, ... 500n stored in the memory array 60 may, depending upon the ECC mode of operation, span over both the main array 60a and the sub-array 60b such as in the high temperature error correction mode, or may be limited to the main array 60a such as in the low temperature error correction mode. Accordingly by not utilizing the sub-array 60b in a mode such as the low temperature error correction mode, to store a line of ECC encoded data, energy savings may be realized, in some applications.

In this embodiment, the main array 60a includes a field 502 in which the bits of the original write data of each line of encoded data may be stored. In one example, the field 502 of a cache memory may be 512 bits long, for example. It is appreciated that in other embodiments, the field 502 may be longer or shorter, depending upon the particular application.

Another field, designated the ECC data field 504, stores the error correction bits of the ECC encoding for each line of data stored in the memory array 60. In this embodiment, the ECC data field 504 spans over both the main array 60a and the subarray 60b and includes a subfield 504a which likewise, spans over both the main array 60a and the sub-array 60b, and is utilized to store the check bits of the long ECC word encoding in the high temperature error correction mode. In the embodiment of FIG. 5a, the long ECC word check bits field 504a for the long ECC word encoding occupies the entire ECC data field 504 of each line of data encoded with the long ECC word encoding. However, it is appreciated that in other embodiments, the size of the long ECC word encoding may vary, depending upon the particular application.

The long ECC word check bits field 504a in turn includes a first subfield 504a1 utilized to store a first portion of the check bits of the ECC encoding in the high temperature error correction mode, and a second subfield 504a2 utilized to store the remaining check bits of the ECC encoding in the high temperature error correction mode. In one embodiment, the check bits of the subfield 504a1 may be utilized as both the check bits of the short ECC word encoding in the low temperature mode, and may also be used as the first portion of the check bits of the long ECC word encoding in the high temperature mode. Hence, the check bits of the field 504a1 are referred to as the short word ECC check bits but may be utilized as both the short word ECC check bits and also as the first portion of the long word ECC check bits. In one example, the field 504a1 of a cache memory may be 10 bits long, for example. It is appreciated that in other embodiments, the field 504a1 may be longer or shorter, depending upon the particular application.

The check bits of the subfield 504a2 are the second portion of the check bits of the long word ECC encoding in the high temperature mode and thus the check bits of the field 504a2 are referred to herein as the long word extension check bits or ECC extension data. In one example, the field 504a2 of a cache memory may be 61 bits long, for example. It is appreciated that in other embodiments, the field 504a2 may be longer or shorter, depending upon the particular application.

Accordingly, the check bits of the long ECC word encoding of the high temperature mode includes both the short word ECC check bits of the subfield 504a1 and the long word extension ECC check bits of the subfield 504a2, of the long word ECC check bits subfield 504a. Conversely, the check bits of the short ECC word encoding of the low temperature mode may include just the short word ECC check bits of the subfield 504a1 of the ECC check bits field 504. Accordingly, in the low temperature error correction mode, the active check bits are stored in the main subarray 60a and do not extend into the subarray 60b, that is are not stored in the subarray 60b. Thus, the check bits stored in the subarray 60b are inactive and the subarray 60b may be permitted to be dormant in which operation is suspended or otherwise operated at reduced or no power, to provide for reduced power consumption of the memory array 60 in the low temperature mode. In addition, because of the short word encoding and decoding, the LTM encoder and decoder may have reduced complexity as compared the counterpart HTM encoder and decoder, such that power consumption by the LTM encoder and decoder may be reduced as compared to that of the HTM encoder and decoder, in some applications.

The write data encoded with the long error correction code word encoding may subsequently be read, decoded and checked for errors. Thus, as another example of an I/O operation, a memory controller such as the memory controller 30 (FIG. 4a) may perform memory read operations in the high temperature error correction mode. In one operation of a memory read operation (FIG. 3b), a memory controller such as the memory controller 30 (FIG. 2) causes data previously encoded in a relatively long ECC code word encoding in the relatively high ECC level of the high temperature ECC mode, to be read from a memory such as the memory circuit 40. The long ECC code word encoded read data including the long ECC word check bits stored in the field 504a, is read and decoded (block 342) by a high temperature mode (HTM) ECC decoder logic 416 (FIG. 4a) of an ECC decoder logic 420 of the multiple mode ECC logic 70.

More specifically, the encoded read data is decoded from the high temperature ECC code encoding of the high temperature ECC encoder logic. As previously mentioned, the high temperature, long word ECC code may be a Reed-Solomon error correction code, for example, but it is appreciated that other error correction codes may be employed in a high temperature, long word error correction code of multiple mode error correction in accordance with the present description.

The ECC decoder logic 416 is configured to decode read data from the memory circuit, which has been encoded in accordance with the high temperature, long word error correction code encoding,. As shown in FIG. 4a, ECC decoder logic 420 is disposed on a die which in this embodiment, is the memory controller die 400. It is appreciated that the ECC decoder logic 420 of multiple mode error correction in accordance with the present description, may be distributed over other types of dies such as the dies of processors, I/O controllers, etc.

In another operation of FIG. 3b, the encoded read data being processed by the high temperature mode (HTM) ECC decoder logic 416 may be checked (block 342, FIG. 3b) by an error detection logic of the high temperature mode (HTM) ECC decoder logic, to determine if the decoded read data contains erroneous data. Such erroneous data may have been caused by corruption of the encoded write data which may have occurred at various stages such as when the encoded write data was transmitted to the memory cell array 60 or while the encoded write data was being stored in the memory cell array 60, or being read from the memory cell array 60 or processed by the ECC logic, for example.

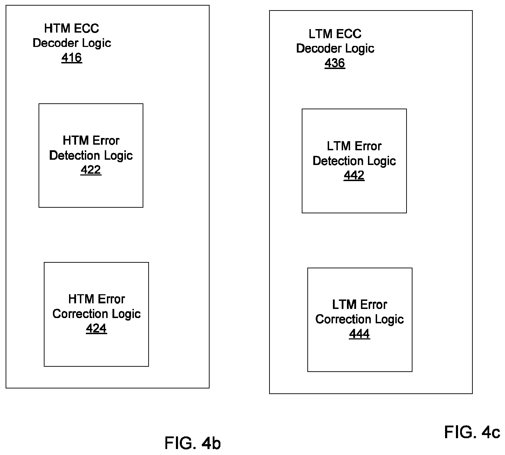

As shown in FIG. 4b, the high temperature mode (HTM) ECC decoder logic 416 of FIG. 4a includes a high temperature mode error detection logic 422 which utilizes the redundant data which was added by the high temperature, long word code encoding as described above, to detect whether the read data being decoded contains errors as indicated by the redundant data stored in the long word ECC check data field 504a (FIG. 5a) of the line of memory being read. If error detection logic 422 detects errors, the errors may be corrected (block 342, FIG. 3b) by suitable correction logic such as the high temperature mode error correction logic 424 (FIG. 4b) of the high temperature mode (HTM) ECC decoder logic 416. Upon completion of the decoding by the high temperature mode (HTM) ECC decoder logic 416, the encoded read data has been fully decoded (and corrected if errors detected) and may be forwarded to the entity requesting the read data.

As previously mentioned, the long word ECC code of one embodiment may be a Reed-Solomon code, for example. Numerous algorithms may be suitable for decoding Reed-Solomon ECC codes. Examples may include Peterson decoders, Berlekamp-Massey decoders, Euclidean decoders, time domain decoders, frequency domain decoders, etc. An outer ECC decoder logic may be implemented in one or more of hardware, software and firmware.

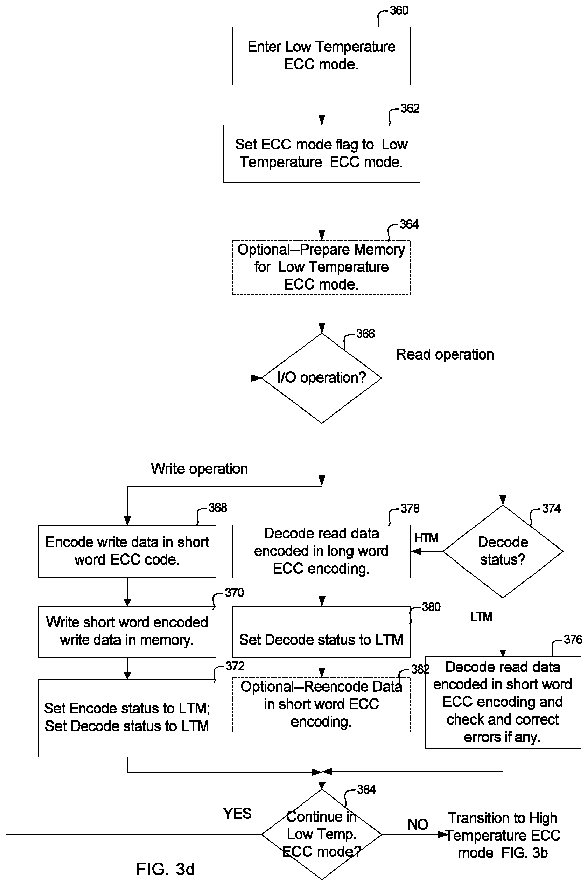

In another operation, a determination (block 346, FIG. 3b) may be made as to whether to continue in the high temperature ECC mode. Such a determination may be made as a function of the output of the memory temperature sensor 80 (FIG. 4a). For example, if the output of the memory temperature sensor 80 indicates that the temperature of the memory remains above the threshold, the multiple mode error correction may remain in the high temperature mode and await the next I/O operation (block 334). Conversely, if the output of the memory temperature sensor 80 indicates that the temperature of the memory has fallen below the threshold, the multiple mode error correction may transition to the low temperature error correction mode described below in connection with FIG. 3d.

FIG. 3c is directed to one example of operations which may be undertaken in preparation (block 330, FIG. 3b) for the high temperature ECC mode. In one embodiment, such preparations may include scanning (block 350, FIG. 3c) each line of the memory array 60 to determine if there are lines of memory which were previously encoded in accordance with a low temperature, short word ECC mode prior to the multiple mode ECC logic entering the high temperature ECC mode.

In the example of FIG. 5a, the memory array 60 is part of a cache memory. Accordingly, the main array 60a includes a field 510 of tag data bits for each line of data stored in the cache memory. The tag data field 510 includes a subfield 510a to store bits used in connection with cache operations. The tag data field 510 further includes, in this embodiment, subfields 510b, 510c to store ECC status bits in connection with error correction encoding and decoding operations of the associated line stored in the cache memory. In one embodiment, the status bits of the subfields may be as few as one bit each, depending upon the particular application. Thus, status bits stored in the subfield 510c, for example, may be indicate whether the associated line of data stored in the cache memory was encoded in a high temperature, long word ECC encoding, or was encoded in a low temperature, short word ECC encoding.

Accordingly, the multiple mode encoder logic 70 (FIG. 4a) may read (block 350, FIG. 3c) each line of the cache memory in turn and examine the associated encode status bit or bits of the encode status field 510c to determined (block 352, FIG. 3c) whether the associated line had been encoded in a low temperature, short word ECC encoding. If so, the high temperature ECC encoder logic 410 can re-encode (block 354) the line of data in a high temperature, long word ECC encoding to prepare that line of data for high temperature operations. For example, lines of cache memory which were encoded in accordance with the low temperature ECC mode may be re-encoded in accordance with the high temperature mode so as to better withstand the higher RBER expected in high temperature operation of the memory.

Once the line of data has been re-encoded in a high temperature, long word ECC encoding, the associated encode status bit or bits of the encode status field 510c may be set (block 356) to indicate that the associated line had been encoded in a high temperature, long word ECC encoding. In addition, an associated decode status bit or bits of the decode status field 510b may be set (block 356) to indicate that the associated line should be decoded in a high temperature, long word ECC decoding. Conversely, if it is determined (block 352, FIG. 3c) that associated line of cache memory has already been encoded in a high temperature, long word ECC encoding as indicated by the encode status field 510c, the high temperature, long word ECC re-encoding of that line of memory may be bypassed. In addition, the setting of encode and decode status fields may be skipped for the associated line of memory in that the status bits will have already been set to indicate encoding and decoding in the high temperature, long word ECC mode.

If it is determined (block 358) that additional lines of the cache memory remain to be scanned, the scanning and re-encoding from low temperature, short word ECC encoding to high temperature, long word ECC encoding may be repeated for each line of cache memory as appropriate until all the lines of cache memory have been scanned and re-encoded as needed. Once all the lines of cache memory have been scanned and re-encoded as needed, the multiple mode error correction logic may proceed to handle I/O operations (block 334, FIG. 3b) as described above in accordance with the high temperature mode.

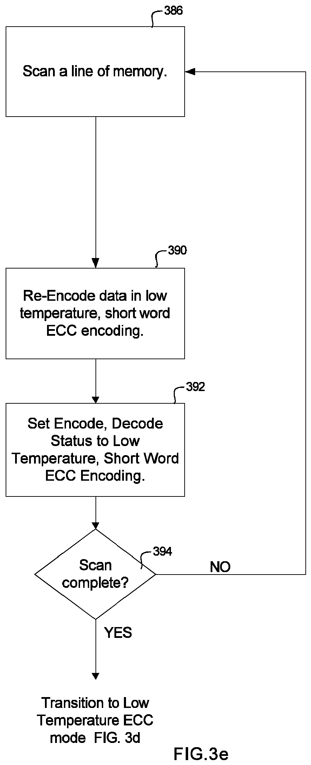

FIG. 3d is directed to operations of the multiple mode ECC logic 70 in a low temperature ECC mode. In connection with entering (block 360, FIG. 3d) the low temperature ECC mode, the ECC mode controller logic 402 (FIG. 4a) of the multiple mode ECC logic 70 sets (block 362) the ECC mode flag 406 (FIG. 4a) to indicate that the multiple mode ECC logic 70 will be operating in the low temperature ECC mode. In accordance with a transition from a high temperature ECC mode to a low temperature ECC mode, preparations (block 364) may optionally be undertaken for the low temperature ECC mode. For example, it is appreciated that such preparations for a low temperature mode may be bypassed in embodiments in which a portion of a high temperature, long word ECC encoding, may be utilized for a low temperature, short word encoding, for example. Conversely, in other embodiments, the high temperature, long word encoding may be fully independent of the low temperature, short word encoding. As such, and as explained in greater detail below in connection with Fig. 3e, in one embodiment, preparations for low temperature mode may include scanning the memory array 60 to determine if there are lines of memory which were previously encoded in accordance with a high temperature ECC mode prior to the multiple mode ECC logic entering the low temperature ECC mode. If so, those lines of memory which were encoded in accordance with the high temperature ECC mode may be re-encoded in accordance with the low temperature mode to accommodate the lower RBER expected in low temperature operation of the memory.

Upon completion of the preparation (if any) of the memory for the low temperature operations, memory I/O operations (block 366) may be processed in a low temperature ECC mode. For example, a memory controller such as the memory controller 30 (FIG. 4a) may receive write data to be written to a memory such as the memory circuit 40. Before the write data is written to the memory, the write data is encoded (block 368) by low temperature mode (LTM) ECC encoder logic 430 (FIG. 4a) of an ECC Encoder Logic 412 of the multiple mode ECC Logic 70. The LTM ECC encoder logic 430 is configured to encode write data in a relatively short ECC code word encoding which provides a relatively low ECC level of error detection and correction capability in accordance with the relatively lower RBER expected during low temperature memory operations. Because the LTM ECC encoder logic 430 employs short word encoding, the complexity of the LTM ECC encoder logic 430 may be reduced as compared to that of the HTM ECC encoder logic 410. As a consequence, the power consumption of the LTM ECC encoder logic 430 in the low temperature mode, may be reduced as compared to that of the HTM ECC encoder logic 410 in the high temperature mode.

One example of a suitable low temperature, short word error correction code is a Reed-Solomon error correction code which is a block code which encodes blocks of data in symbols to facilitate error detection and correction. It is appreciated that other types of error correction codes may be employed in low temperature mode, multiple mode error correction in accordance with the present description. For example, it is believed that both block and convolutional codes may be suitable as a short word code for multiple mode error correction in accordance with the present description. Also, it is believed that both systematic and nonsystematic codes may be suitable as a short word code for multiple mode error correction in accordance with the present description. Additional examples of codes which may be suitable as short word codes are recursive codes, non-recursive codes, repetition codes, Hamming codes, multidimensional parity-check codes, turbo codes, low-density parity-check codes (LDPC), etc. The low temperature mode (LTM) ECC encoder logic 430 is configured to encode write data for the memory circuit in a short word error correction code (such as a Reed-Solomon error correction code, for example) of the temperature dependent, multiple mode error correction in accordance with one embodiment of the present description.

In one embodiment, the low temperature mode (LTM) ECC encoder logic 430 encodes the write data in a short error correction code word which adds redundant data such as check bits for example. Examples of redundant check bit data which may be added for purposes of error detection and correction include parity bits, repetition codes, checksums and cyclic redundancy checks (CRCs). The write data encoded with the check bits of the short error correction code word encoding may be stored (block 370, FIG. 3d) in a memory such as the memory array 60 (FIG. 5a). As explained in greater detail below, the write data encoded in the short error correction code word encoding may subsequently be decoded and checked for errors. In many cases, depending upon the severity of the detected errors, the decoded data may be corrected and restored to its original error-free form before it was written to the memory.

As previously mentioned, the long ECC word check bits field 504a includes a first subfield 504a1 utilized to store a first portion of the check bits of the ECC encoding in the high temperature error correction mode. In the low temperature, short word ECC encoding, the check bits generated may be stored in the same field 504a1 which is designated the short word ECC data field 504a1 in FIG. 5a. Thus, check bits of the short ECC word encoding of the low temperature mode may include just the short word ECC check bits of the subfield 504a1 of the ECC check bits field 504. Accordingly, in the low temperature error correction mode, the subarray 60b containing the field 504a2 utilized in high temperature, long word ECC encoding, may be dormant or otherwise operated at reduced or no power, to provide for reduced power consumption of the memory array 60a in the low temperature mode.

In another operation, the encode status field 510c for the line of data written to memory may be set (block 372) to indicate that the line of data was encoded in a low temperature, short word ECC encoding. Similarly, the decode status field 510b may be set (block 372) for the line of data written to memory to indicate that the line of data is to be decoded in a low temperature, short word ECC decoding.

The write data encoded in a multiple mode ECC encoding may subsequently be read, decoded and checked for errors. Thus, as another example of an I/O operation, a memory controller such as the memory controller 30 (FIG. 4a) may perform memory read operations in the low temperature error correction mode. In one operation of a memory read operation (FIG. 3d), a memory controller such as the memory controller 30 (FIG. 2) causes previously encoded data to be read and the decode status for that line of data checked (block 374). If the decode status field 510b of the line of data read from the memory indicates that the line of data was previously encoded in the low temperature, short word ECC encoding, the low temperature, short word encoded read data may be decoded (block 376) by a low temperature mode (LTM) ECC decoder logic 436 (FIG. 4a) of the ECC decoder logic 420 of the multiple mode ECC logic 70. In one embodiment, the low temperature, short word decoding may be a less robust error detection and correction level in keeping with the lower RBER expected in low temperature operations. Because the LTM ECC decoder logic 436 employs short word decoding, the complexity of the LTM ECC decoder logic 436 may be reduced as compared to that of the HTM ECC decoder logic 416. As a consequence, the power consumption of the LTM ECC decoder logic 436 in the low temperature mode, may be reduced as compared to that of the HTM ECC decoder logic 416 in the high temperature mode.

Thus,, the encoded read data is decoded from the low temperature, short word ECC encoding provided by the low temperature ECC encoder logic. As previously mentioned, the low temperature, short word ECC code may be a Reed-Solomon error correction code, for example, but it is appreciated that other error correction codes may be employed in a low temperature, short word error correction code decoding of multiple mode error correction in accordance with the present description.

FIG. 4a shows an embodiment of the memory controller die 400 of the memory controller 30 which includes the low temperature mode (LTM) ECC decoder logic 436 of an ECC decoder logic 420 of the multiple mode ECC logic 70. The ECC decoder logic 436 is configured to decode in accordance with the low temperature, short word error correction code, encoded read data from the memory circuit.

In another operation of FIG. 3b, the encoded read data being processed by the low temperature mode (LTM) ECC decoder logic 436 may be checked (block 376, FIG. 3d) by an error detection logic of the low temperature mode (LTM) ECC decoder logic, to determine if the decoded read data contains erroneous data. Such erroneous data may have been caused by corruption of the encoded write data which may have occurred at various stages such as when the encoded write data was transmitted to the memory cell array 60 or while the encoded write data was being stored in the memory cell array 60, or being read from the memory cell array 60 or processed by the ECC logic, for example.

As shown in FIG. 4c, the low temperature mode (LTM) ECC decoder logic 436 of FIG. 4a includes a low temperature mode error detection logic 442 which utilizes the redundant data which was added by the low temperature, short word code encoding as described above, to detect whether the read data being decoded contains errors as indicated by the redundant data stored in the short word ECC data field 504a1 (FIG. 5a) of the line of memory being read. If error detection logic 442 detects errors, the errors may be corrected (block 376, FIG. 3d) by suitable correction logic such as the low temperature mode error correction logic 444 (FIG. 4c) of the low temperature mode (LTM) ECC decoder logic 436. Upon completion of the decoding by the low temperature mode (LTM) ECC decoder logic 436, the encoded read data has been fully decoded (and corrected if errors detected) and may be forwarded to the entity requesting the read data.

As previously mentioned, the low temperature, short word ECC code of one embodiment may be a Reed-Solomon code, for example. Numerous algorithms may be suitable for decoding Reed-Solomon ECC codes. Examples may include Peterson decoders, Berlekamp-Massey decoders, Euclidean decoders, time domain decoders, frequency domain decoders, etc. An outer ECC decoder logic may be implemented in one or more of hardware, software and firmware.

As previously mentioned, a memory controller such as the memory controller 30 (FIG. 2) causes previously encoded data to be read and the decode status for that line of data checked (block 374). If the decode status field 510b of the line of data read from the memory indicates that the line of data is to be decoded from the high temperature, long word ECC encoding, the high temperature, long word encoded read data may be decoded (block 378) by the high temperature mode (HTM) ECC decoder logic 416 (FIG. 4a) as described above. Accordingly, data which was encoded for high temperature operations using high temperature, long word encoding, is decoded using the high temperature, long word encoding to provide the more robust level of error detection and correction to compensate for a higher RBER which may have been encountered while the line of data was stored in the memory. In subsequent readings of the line of data, the line of data may be decoded using the low temperature, short word ECC encoding in keeping with the mode of operation of the multiple mode error correction being in the low temperature mode of operation. Accordingly, the decode status is set (block 380) for the line of data read from memory to indicate that the line of data in subsequent readings is to be decoded in a low temperature, short word ECC decoding.

In the embodiment of FIG. 5a, the check bits encoded with the high temperature, long word ECC encoding and stored in the short word ECC data field 504a1 may be utilized for the low temperature, short word decoding described above. Hence, the check bits of the field 504a1 are common bits to both a low temperature, short word ECC encoding and a high temperature, long word encoding. Hence, where the check bits of the field 504a1 may be utilized for both low temperature, short word decoding and high temperature, long word decoding, the check bits of the field 504a1 need not be re-encoded when transitioning from a high temperature mode of operations to a low temperature mode of operations. US Pat. No. 8533572 describes error correction for caches which can utilize a common set of check bits. However, in other embodiments, such as where the low temperature, short word encoding and the high temperature, long word encoding may not share check bits, a re-encoding (block 382) of the data to a low temperature, short word encoding may be appropriate.

In another operation, a determination (block 384, FIG. 3b) may be made as to whether to continue in the low temperature ECC mode. Such a determination may be made as a function of the output of the memory temperature sensor 80 (FIG. 4a). For example, if the output of the memory temperature sensor 80 indicates that the temperature of the memory remains below the threshold, the multiple mode error correction may remain in the low temperature mode and await the next I/O operation (block 366). Conversely, if the output of the memory temperature sensor 80 indicates that the temperature of the memory has risen above the threshold, the multiple mode error correction may transition to the high temperature error correction mode described above in connection with FIG. 3b.

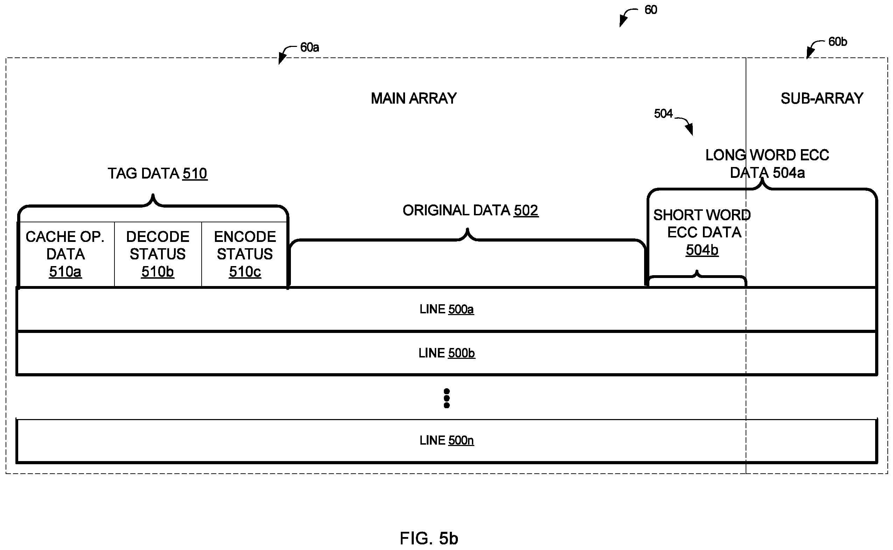

FIG. 5b is directed to an embodiment which differs from the embodiment of FIG. 5a in that the high temperature, long word ECC encoding does not share check bits with the low temperature, short word ECC encoding. Accordingly, the check bits stored in a short word ECC data subfield 504b of the ECC data field 504 are independent of check bits stored in the long word ECC data field 504a of the ECC data field 504. As a result, check bits generated by high temperature, long word ECC encoding are not used as check bits in a low temperature mode. Instead, high temperature, long word ECC encodings are re-encoded to a low temperature, short word ECC encoding when transitioning from a high temperature mode to a low temperature mode.

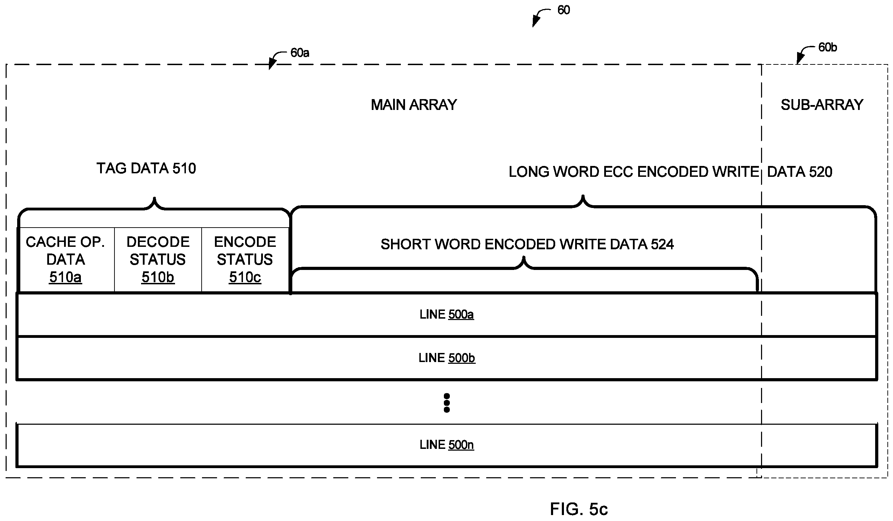

Similarly, FIG. 5c is directed to an embodiment which differs from the embodiment of FIG. 5a in that the high temperature, long word ECC encoding does not share check bits with the low temperature, short word ECC encoding. In addition, the ECC correction of FIG. 5c utilizes a non-systematic code, such that the original write data is transformed into an encoded message that typically has at least as many bits as the original message. Accordingly, in the embodiment of FIG. 5c, in the high temperature, long word ECC encoding, the original write data and the redundant check data are transformed into an encoded message stored in a long word ECC encoded write data field 520 which spans both the main array 60a and the sub-array 60b. In the low temperature, short word ECC encoding, the original write data and the redundant check data are transformed into a shorter encoded message stored in a short word ECC encoded write data field 524 within the main array 60a and does not extend into sub-array 60b.

Thus, in both of the embodiments of FIGs. 5b and 5c, as well as the embodiment of FIG. 5a, the low temperature, short word encoding does not extend into the sub-array 60b. Hence, in the low temperature mode, the sub-array 60b may be dormant to reduce power consumption in each of the embodiments of FIG. 5a-5c.

However, because the low temperature, short word ECC encoding of the embodiments of FIGs. 5b, 5c are independent of the high temperature, long word ECC encodings such that check bits are not shared between the two modes of encoding, the high temperature encodings of the high temperature mode may be re-encoded to low temperature encodings when entering the low temperature mode from the high temperature mode.

FIG. 3e is directed to one example of operations which may be undertaken in preparation (block 330, FIG. 3b) for operating in the low temperature ECC mode. In one embodiment, such preparations may include scanning (block 386, FIG. 3e) each line of the memory array 60 . Accordingly, the multiple mode encoder logic 70 (FIG. 4a) may read (block 386, FIG. 3e) each line of the cache memory in turn and the low temperature ECC encoder logic 430 can re-encode (block 390) the line of data in a low temperature, short word ECC encoding to prepare that line of data for low temperature operations so as to take advantage of the lower RBER expected in low temperature operation of the memory.

Once the line of data has been re-encoded in a low temperature, short word ECC encoding, the associated encode status bit or bits of the encode status field 510c may be set (block 392) to indicate that the associated line had been encoded in a low temperature, short word ECC encoding. In addition, associated decode status bit or bits of the decode status field 510b may be set (block 392) to indicate that the associated line should be decoded in a low temperature, short word ECC decoding.

If it is determined (block 394) that additional lines of the cache memory remain to be scanned, the scanning and re-encoding from high temperature, long word ECC encoding to low temperature, short word ECC encoding may be repeated for each line of cache memory as appropriate until all the lines of cache memory have been scanned and re-encoded. Once all the lines of cache memory have been scanned and re-encoded, the multiple mode error correction logic may proceed to handle I/O operations as described above in accordance with the low temperature mode.

It is seen from the above, that temperature dependent, multiple mode error correction in accordance with the present description, may reduce power consumption in a low temperature mode. Other aspects and advantages may be achieved, depending upon the particular application.

The described operations may be implemented as a method, apparatus or computer program product using standard programming and/or engineering techniques to produce software, firmware, hardware, or any combination thereof. The described operations may be implemented as computer program code maintained in a "computer readable storage medium", where a processor may read and execute the code from the computer storage readable medium. The computer readable storage medium includes at least one of electronic circuitry, storage materials, inorganic materials, organic materials, biological materials, a casing, a housing, a coating, and hardware. A computer readable storage medium may comprise, but is not limited to, a magnetic storage medium (e.g., hard disk drives, floppy disks, tape, etc.), optical storage (CD-ROMs, DVDs, optical disks, etc.), volatile and non-volatile memory devices (e.g., EEPROMs, ROMs, PROMs, RAMs, DRAMs, SRAMs, Flash Memory, firmware, programmable logic, etc.), Solid State Devices (SSD), etc. The code implementing the described operations may further be implemented in hardware logic implemented in a hardware device (e.g., an integrated circuit chip, Programmable Gate Array (PGA), Application Specific Integrated Circuit (ASIC), etc.). Still further, the code implementing the described operations may be implemented in "transmission signals", where transmission signals may propagate through space or through a transmission media, such as an optical fiber, copper wire, etc. The transmission signals in which the code or logic is encoded may further comprise a wireless signal, satellite transmission, radio waves, infrared signals, Bluetooth, etc. The program code embedded on a computer readable storage medium may be transmitted as transmission signals from a transmitting station or computer to a receiving station or computer. A computer readable storage medium is not comprised solely of transmissions signals. Those skilled in the art will recognize that many modifications may be made to this configuration without departing from the scope of the present description, and that the article of manufacture may comprise suitable information bearing medium known in the art. Of course, those skilled in the art will recognize that many modifications may be made to this configuration without departing from the scope of the present description, and that the article of manufacture may comprise any tangible information bearing medium known in the art.

In certain applications, a device in accordance with the present description, may be embodied in a computer system including a video controller to render information to display on a monitor or other display coupled to the computer system, a device driver and a network controller, such as a computer system comprising a desktop, workstation, server, mainframe, laptop, handheld computer, etc. Alternatively, the device embodiments may be embodied in a computing device that does not include, for example, a video controller, such as a switch, router, etc., or does not include a network controller, for example.

The illustrated logic of figures may show certain events occurring in a certain order. In alternative embodiments, certain operations may be performed in a different order, modified or removed. Moreover, operations may be added to the above described logic and still conform to the described embodiments. Further, operations described herein may occur sequentially or certain operations may be processed in parallel. Yet further, operations may be performed by a single processing unit or by distributed processing units.

The foregoing description of various embodiments has been presented for the purposes of illustration and description. It is not intended to be exhaustive or to limit to the precise form disclosed. Many modifications and variations are possible in light of the above teaching.

## Claims

1. An apparatus, comprising:
an array of memory cells (60) of a memory circuit ;
a temperature sensor (80) coupled to the array and having an output, said temperature sensor configured to provide an output signal at said output wherein the output signal is a function of the temperature of the array of memory cells;
a memory controller (400) electrically coupled to the array of cells of the memory circuit and configured to control the array of memory cells; and
multiple mode error correction code logic (70) having an input coupled to the temperature sensor output, said multiple mode error correction code logic configured to encode write data for the array of memory cells in an error correction code in one of a plurality of error correction modes as a function of the temperature of the array of memory cells,
wherein said plurality of error correction modes includes a first error correction mode at a first error correction level at a first memory cell array temperature level, and further includes a second error correction mode at a second error correction level lower than the first error correction level at a second memory cell array temperature level lower than the first memory cell array temperature level,
wherein the array of memory cells includes a subarray (60b), and wherein the multiple mode error correction code logic is configured to encode write data for the array of memory cells in the first error correction mode at the first error correction level to provide an error correction code word having a first length, at least a portion of which is stored in the subarray of memory cells, and is configured to encode write data for the array of memory cells in the second error correction mode at the second error correction level to provide an error correction code word having a second length shorter than the first length and which is not stored within the subarray, is configured to decode read data from the array of memory cells encoded in an error correction code word having the first length, and is configured to decode read data from the array of memory cells encoded in an error correction code word having the second length shorter than the first length, and
wherein, in the second error correction mode at the second error correction level at the second memory cell array temperature level, the subarray (60b) is configured to be dormant in which operation is suspended or otherwise operated at reduced or no power.

2. The apparatus of claim 1 wherein said multiple mode error correction code logic is further configured to set an encode status flag (510c) to indicate whether the write data associated with the encode status flag was encoded at the first error correction level or at the second error correction level lower than the first error correction level, and wherein said multiple mode error correction code logic is further configured to enter the first error correction mode in response to the temperature sensor output signal indicating that the temperature of the array of memory cells has exceeded a threshold level, and to scan the array of memory cells to detect whether the encode status flag has been set for write data and to re-encode write data at the first error correction level in response to a detection of the encode status flag being set for the associated write data indicating that the associated write data had been encoded at the second error correction level.

3. The apparatus of claim 2 wherein said multiple mode error correction code logic is further configured to reset the encode status flag for write data re-encoded at the first error correction level to indicate that the write data associated with the reset encode status flag was re-encoded at the first error correction level higher than the second error correction level.

4. The apparatus of claim 3 wherein the multiple mode error correction code logic is further configured to set a decode status flag (510b) for read data to indicate the error correction level at which the associated read data may be decoded.

5. The apparatus of claim 4 wherein said multiple mode error correction code logic is further configured to:
enter the second error correction mode in response to the temperature sensor output signal indicating that the temperature of the array of memory cells has fallen below a threshold level;
detect the decode status flag;
read and decode read data at the second error correction level in response to a detection of the decode status flag being set for the associated read data to indicate that the read data may be decoded at the second error correction level, and
in response to a detection of the decode status flag being set for the associated read data to indicate that the read data is to be decoded at the first error correction level, read and decode read data at the first error correction level and reset the decode status flag to indicate that the read data may be decoded at the second error correction level.

6. The apparatus of any one of claims 1-5 wherein the array of memory cells is a spin-transfer-torque random-access-memory cache.

7. The apparatus of any of claims 1-6 for use with a display, further comprising:
a memory wherein the memory includes the memory circuit having said array of memory cells and the memory controller;
a processor configured to write data in and read data from the memory; and
a video controller configured to display information represented by data in the memory.

8. A method, comprising:
sensing the temperature of an array of memory cells using a temperature sensor coupled to the array; and
performing error correction processing of data using multiple mode error correction code logic, said processing including encoding write data for the array of memory cells in an error correction code in one of a plurality of error correction modes as a function of the temperature of the array of memory cells,
wherein said encoding write data for the array of memory cells in an error correction code in one of a plurality of error correction modes includes encoding write data in a first error correction mode at a first error correction level at a first memory cell array temperature level, and further includes encoding write data in a second error correction mode at a second error correction level lower than the first error correction level at a second memory cell array temperature level lower than the first memory cell array temperature level,
wherein the array of memory cells includes a subarray, and wherein the encoding write data in a first error correction mode includes providing an error correction code word having a first length, and storing at least a portion of the error correction code word having the first length in the subarray of memory cells, and encoding write data in a second error correction mode includes providing an error correction code word having a second length shorter than the first length, storing the error correction code word having the second length outside the subarray, said processing further including decoding read data from the array of memory cells encoded in an error correction code word having the first length, and decoding read data from the array of memory cells encoded in an error correction code word having the second length shorter than the first length, and
wherein, in the second error correction mode at the second error correction level at the second memory cell array temperature level, the subarray (60b) is dormant in which operation is suspended or otherwise operated at reduced or no power.

9. The method of claim 8 wherein said processing further includes setting an encode status flag (510c) to indicate whether the write data associated with the encode status flag was encoded at the first error correction level or at the second error correction level lower than the first error correction level, and further includes entering the first error correction mode in response to the temperature sensor indicating that the temperature of the array of memory cells has exceeded a threshold level, and scanning the array of memory cells to detect the encode status flag and re-encoding write data at the first error correction level in response to a detection of the encode status flag for the associated write data indicating that the associated write data had been encoded at the second error correction level.

10. The method of claim 9 wherein the processing further includes resetting an encode status flag for write data re-encoded at the first error correction level to indicate that the write data associated with the reset encode status flag was re-encoded at the first error correction level higher than the second error correction level;
setting a decode status flag for read data to indicate the error correction level at which the associated read data may be decoded;
entering the second error correction mode in response to the temperature sensor indicating that the temperature of the array of memory cells has fallen below a threshold level;
detecting the decode status flag;
reading and decoding read data at the second error correction level in response to a detection of the decode status flag indicating that the read data may be decoded at the second error correction level, and
in response to a detection of the decode status flag indicating that the read data is to be decoded at the first error correction level, reading and decoding read data at the first error correction level and resetting the decode status flag to indicate that the read data may be decoded at the second error correction level; and
wherein the array of memory cells is a spin-transfer-torque random-access-memory cache.

## Patentansprüche

1. Vorrichtung, die Folgendes umfasst:
eine Anordnung (60) von Speicherzellen einer Speicherschaltung;
einen Temperatursensor (80), der mit der Anordnung gekoppelt ist und einen Ausgang aufweist, wobei der Temperatursensor konfiguriert ist, an dem Ausgang ein Ausgangssignal bereitzustellen, wobei das Ausgangssignal eine Funktion der Temperatur der Anordnung von Speicherzellen ist;
eine Speichersteuereinheit (400), die mit der Anordnung von Zellen der Speicherschaltung elektrisch gekoppelt und konfiguriert ist, die Anordnung von Speicherzellen zu steuern; und
eine Fehlerkorrekturcode-Logik (70) mit mehreren Betriebsarten, die einen Eingang aufweist, der mit dem Temperatursensorausgang gekoppelt ist, wobei die Fehlerkorrekturcode-Logik mit mehreren Betriebsarten konfiguriert ist, in einer von mehreren Fehlerkorrekturbetriebsarten Schreibdaten für die Anordnung von Speicherzellen als eine Funktion der Temperatur der Anordnung von Speicherzellen in einen Fehlerkorrekturcode zu codieren,
wobei die mehreren Fehlerkorrekturbetriebsarten eine erste Fehlerkorrekturbetriebsart mit einer ersten Fehlerkorrekturstufe bei einem ersten Temperaturwert der Speicherzellenanordnung enthalten und ferner eine zweite Fehlerkorrekturbetriebsart mit einer zweiten Fehlerkorrekturstufe, die niedriger als die erste Fehlerkorrekturstufe ist, bei einem zweiten Temperaturwert der Speicherzellenanordnung, der niedriger als der erste Temperaturwert der Speicherzellenanordnung ist, enthalten,
wobei die Anordnung von Speicherzellen eine Unteranordnung (60b) enthält und wobei die Fehlerkorrekturcode-Logik mit mehreren Betriebsarten konfiguriert ist, in der ersten Fehlerkorrekturbetriebsart mit der ersten Fehlerkorrekturstufe Schreibdaten für die Anordnung von Speicherzellen zu codieren, derart, dass ein Fehlerkorrekturcodewort mit einer ersten Länge, wovon zumindest ein Abschnitt in der Unteranordnung von Speicherzellen gespeichert wird, bereitgestellt wird, und konfiguriert ist, in der zweiten Fehlerkorrekturbetriebsart mit der zweiten Fehlerkorrekturstufe Schreibdaten für die Anordnung von Speicherzellen zu codieren, derart, dass ein Fehlerkorrekturcodewort mit einer zweiten Länge, die kürzer als die erste Länge ist, und das nicht in der Unteranordnung gespeichert wird, bereitgestellt wird, konfiguriert ist, Lesedaten aus der Anordnung von Speicherzellen zu decodieren, die in einem Fehlerkorrekturcodewort mit der ersten Länge codiert sind, und konfiguriert ist, Lesedaten aus der Anordnung von Speicherzellen zu decodieren, die in einem Fehlerkorrekturcodewort mit der zweiten Länge, die kürzer als die erste Länge ist, codiert sind, und
wobei in der zweiten Fehlerkorrekturbetriebsart mit der zweiten Fehlerkorrekturstufe bei dem zweiten Temperaturwert der Speicherzellenanordnung die Unteranordnung (60b) konfiguriert ist, sich in einem Ruhezustand zu befinden, in dem der Betrieb ausgesetzt ist, oder auf andere Weise mit verringerter oder keiner Leistung betrieben zu werden.

2. Vorrichtung nach Anspruch 1, wobei die Fehlerkorrekturcode-Logik mit mehreren Betriebsarten ferner konfiguriert ist, ein Codierungszustandskennzeichen (510c) einzustellen, um anzugeben, ob die Schreibdaten, die dem Codierungszustandskennzeichen zugeordnet sind, mit der ersten Fehlerkorrekturstufe oder mit der zweiten Fehlerkorrekturstufe, die niedriger als die erste Fehlerkorrekturstufe ist, codiert worden sind, und wobei die Fehlerkorrekturcode-Logik mit mehreren Betriebsarten ferner konfiguriert ist, als Antwort darauf, dass das Temperatursensorausgangssignal angibt, dass die Temperatur der Anordnung von Speicherzellen einen Schwellenwert überschritten hat, in die erste Fehlerkorrekturbetriebsart einzutreten und die Anordnung von Speicherzellen abzutasten, um zu detektieren, ob das Codierungszustandskennzeichen für Schreibdaten eingestellt worden ist, und als Antwort auf eine Detektion, dass das Codierungszustandskennzeichen, das für die zugeordneten Schreibdaten eingestellt worden ist, angibt, dass die zugeordneten Schreibdaten mit der zweiten Fehlerkorrekturstufe codiert wurden, die Schreibdaten mit der ersten Fehlerkorrekturstufe erneut zu codieren.

3. Vorrichtung nach Anspruch 2, wobei die Fehlerkorrekturcode-Logik mit mehreren Betriebsarten ferner konfiguriert ist, das Codierungszustandskennzeichen für Schreibdaten, die mit der ersten Fehlerkorrekturstufe erneut codiert worden sind, zurückzusetzen, um anzugeben, dass die Schreibdaten, die dem zurückgesetzten Codierungszustandskennzeichen zugeordnet sind, mit der ersten Fehlerkorrekturstufe, die höher als die zweite Fehlerkorrekturstufe ist, erneut codiert wurden.

4. Vorrichtung nach Anspruch 3, wobei die Fehlerkorrekturcode-Logik mit mehreren Betriebsarten ferner konfiguriert ist, ein Decodierungszustandskennzeichen (510b) für Lesedaten einzustellen, um die Fehlerkorrekturstufe anzugeben, mit der die zugeordneten Lesedaten decodiert werden können.

5. Vorrichtung nach Anspruch 4, wobei die Fehlerkorrekturcode-Logik mit mehreren Betriebsarten ferner konfiguriert ist zum:
Eintreten in die zweite Fehlerkorrekturbetriebsart als Antwort darauf, dass das Temperatursensorausgangssignal angibt, dass die Temperatur der Anordnung von Speicherzellen unter einen Schwellenwert abgefallen ist;
Detektieren des Decodierungszustandskennzeichens;
Lesen und Decodieren von Lesedaten mit der zweiten Fehlerkorrekturstufe als Antwort auf eine Detektion, dass das Decodierungszustandskennzeichen für die zugeordneten Lesedaten derart eingestellt ist, dass angegeben wird, dass die Lesedaten mit der zweiten Fehlerkorrekturstufe decodiert werden können; und
als Antwort auf eine Detektion, dass das Decodierungszustandskennzeichen für die zugeordneten Lesedaten derart eingestellt ist, dass angegeben wird, dass die Lesedaten mit der ersten Fehlerkorrekturstufe decodiert werden sollen, Lesen und Decodieren der Lesedaten mit der ersten Fehlerkorrekturstufe und Zurücksetzen des Decodierungszustandskennzeichens, um anzugeben, dass die Lesedaten mit der zweiten Fehlerkorrekturstufe decodiert werden können.

6. Vorrichtung nach einem der Ansprüche 1-5, wobei die Anordnung von Speicherzellen ein Cache-Speicher des Typs eines "Spin Transfer Torque"-Schreib/Lese-Speichers ist.

7. Vorrichtung nach einem der Ansprüche 1-6 zur Verwendung mit einer Anzeige, die ferner Folgendes umfasst:
einen Speicher, wobei der Speicher die Speicherschaltung enthält, die die Anordnung von Speicherzellen und die Speichersteuereinheit aufweist;
einen Prozessor, der konfiguriert ist, Daten in den Speicher zu schreiben und Daten aus dem Speicher zu lesen; und
eine Videosteuereinheit, die konfiguriert ist, Informationen anzuzeigen, die durch Daten in dem Speicher dargestellt werden.

8. Verfahren, das Folgendes umfasst:
Erfassen der Temperatur einer Anordnung von Speicherzellen unter Verwendung eines Temperatursensors, der mit der Anordnung gekoppelt ist; und
Durchführen einer Fehlerkorrekturverarbeitung von Daten unter Verwendung einer Fehlerkorrekturcode-Logik mit mehreren Betriebsarten, wobei die Verarbeitung das Codieren von Schreibdaten für die Anordnung von Speicherzellen in einem Fehlerkorrekturcode in einer von mehreren Fehlerkorrekturbetriebsarten als eine Funktion der Temperatur der Anordnung von Speicherzellen enthält,
wobei das Codieren von Schreibdaten für die Anordnung von Speicherzellen in einem Fehlerkorrekturcode in einer von mehreren Fehlerkorrekturbetriebsarten das Codieren von Schreibdaten in einer ersten Fehlerkorrekturbetriebsart mit einer ersten Fehlerkorrekturstufe bei einem ersten Temperaturwert der Speicherzellenanordnung enthält und ferner das Codieren von Schreibdaten in einer zweiten Fehlerkorrekturbetriebsart mit einer zweiten Fehlerkorrekturstufe, die niedriger als die erste Fehlerkorrekturstufe ist, bei einem zweiten Temperaturwert der Speicherzellenanordnung, der niedriger als der erste Temperaturwert der Speicherzellenanordnung ist, enthält,
wobei die Anordnung von Speicherzellen eine Unteranordnung enthält und wobei das Codieren von Schreibdaten in einer ersten Fehlerkorrekturbetriebsart das Bereitstellen eines Fehlerkorrekturcodewortes mit einer ersten Länge und das Speichern zumindest eines Abschnitts des Fehlerkorrekturcodewortes mit der ersten Länge in der Unteranordnung von Speicherzellen enthält und das Codieren von Schreibdaten in einer zweiten Fehlerkorrekturbetriebsart das Bereitstellen eines Fehlerkorrekturcodewortes mit einer zweiten Länge, die kürzer als die erste Länge ist, und das Speichern des Fehlerkorrekturcodewortes mit der zweiten Länge außerhalb der Unteranordnung enthält,
wobei die Verarbeitung ferner das Decodieren von Lesedaten aus der Anordnung von Speicherzellen, die in einem Fehlerkorrekturcodewort mit der ersten Länge codiert sind, und das Decodieren von Lesedaten aus der Anordnung von Speicherzellen, die in einem Fehlerkorrekturcodewort mit der zweiten Länge, die kürzer als die erste Länge ist, codiert sind, enthält, und
wobei in der zweiten Fehlerkorrekturbetriebsart mit der zweiten Fehlerkorrekturstufe bei dem zweiten Temperaturwert der Speicherzellenanordnung die Unteranordnung (60b) sich in einem Ruhezustand befindet, in dem der Betrieb ausgesetzt ist, oder auf andere Weise mit verringerter oder keiner Leistung betrieben wird.

9. Verfahren nach Anspruch 8, wobei die Verarbeitung ferner das Einstellen eines Codierungszustandskennzeichens (510c), um anzugeben, ob die Schreibdaten, die dem Codierungszustandskennzeichen zugeordnet sind, mit der ersten Fehlerkorrekturstufe oder mit der zweiten Fehlerkorrekturstufe, die niedriger als die erste Fehlerkorrekturstufe ist, codiert wurden, enthält und ferner das Eintreten in die erste Fehlerkorrekturbetriebsart als Antwort darauf, dass der Temperatursensor angibt, dass die Temperatur der Anordnung von Speicherzellen einen Schwellenwert überschritten hat, und das Abtasten der Anordnung von Speicherzellen, um das Codierungszustandskennzeichen zu detektieren, und das erneute Codieren von Schreibdaten mit der ersten Fehlerkorrekturstufe als Antwort auf eine Detektion, dass das Codierungszustandskennzeichen für die zugeordneten Schreibdaten angibt, dass die zugeordneten Schreibdaten mit der zweiten Fehlerkorrekturstufe kodiert wurden, enthält.

10. Verfahren nach Anspruch 9, wobei die Verarbeitung ferner Folgendes enthält:
Zurücksetzen eines Codierungszustandskennzeichens für Schreibdaten, die mit der ersten Fehlerkorrekturstufe erneut codiert worden sind, um anzugeben, dass die Schreibdaten, die dem zurückgesetzten Codierungszustandskennzeichen zugeordnet sind, mit der ersten Fehlerkorrekturstufe, die höher als die zweite Fehlerkorrekturstufe ist, erneut codiert wurden;
Einstellen eines Decodierungszustandskennzeichens für Lesedaten, um die Fehlerkorrekturstufe anzugeben, mit der die zugeordneten Lesedaten decodiert werden können;
Eintreten in die zweite Fehlerkorrekturbetriebsart als Antwort darauf, dass der Temperatursensor angibt, dass die Temperatur der Anordnung von Speicherzellen unter einen Schwellenwert abgefallen ist;
Detektieren des Decodierungszustandskennzeichens;
Lesen und Decodieren der Lesedaten mit der zweiten Fehlerkorrekturstufe als Antwort auf eine Detektion, dass das Decodierungszustandskennzeichen angibt, dass die Lesedaten mit der zweiten Fehlerkorrekturstufe decodiert werden können; und
als Antwort auf eine Detektion, dass das Decodierungszustandskennzeichen angibt, dass die Lesedaten mit der ersten Fehlerkorrekturstufe decodiert werden sollen, Lesen und Decodieren der Lesedaten mit der ersten Fehlerkorrekturstufe und Zurücksetzen des Decodierungszustandskennzeichens, um anzugeben, dass die Lesedaten mit der zweiten Fehlerkorrekturstufe decodiert werden können; und
wobei die Anordnung von Speicherzellen ein Cache-Speicher des Typs eines "Spin Transfer Torque"-Schreib/Lese-Speichers ist.

## Revendications

1. Appareil, comprenant :
une matrice de cellules de mémoire (60) d'un circuit de mémoire ;
un capteur de température (80) couplé à la matrice et pourvu d'une sortie, ledit capteur de température étant configuré pour fournir un signal de sortie à ladite sortie, le signal de sortie étant une fonction de la température de la matrice de cellules de mémoire ;
un contrôleur de mémoire (400) couplé électriquement à la matrice de cellules du circuit de mémoire et configuré pour commander la matrice de cellules de mémoire ; et
une logique de code de correction d'erreur multimode (70) pourvue d'une entrée couplée à la sortie du capteur de température, ladite logique de code de correction d'erreur multimode étant configurée pour coder des données en écriture pour la matrice de cellules de mémoire dans un code de correction d'erreur dans l'un d'une pluralité de modes de correction d'erreur en fonction de la température de la matrice de cellules de mémoire,
ladite pluralité de modes de correction d'erreur comportant un premier mode de correction d'erreur à un premier niveau de correction d'erreur à un premier niveau de température de la matrice de cellules de mémoire, et comportant en outre un deuxième mode de correction d'erreur à un deuxième niveau de correction d'erreur inférieur au premier niveau de correction d'erreur à un deuxième niveau de température de la matrice de cellules de mémoire inférieur au premier niveau de température de la matrice de cellules de mémoire,
la matrice de cellules de mémoire comportant une sous-matrice (60b), et la logique de code de correction d'erreur multimode étant configurée pour coder des données en écriture pour la matrice de cellules de mémoire dans le premier mode de correction d'erreur au premier niveau de correction d'erreur pour fournir un mot de code de correction d'erreur pourvu d'une première longueur, dont au moins une partie est enregistrée dans la sous-matrice de cellules de mémoire, et étant configurée pour coder des données en écriture pour la matrice de cellules de mémoire dans le deuxième mode de correction d'erreur au deuxième niveau de correction d'erreur pour fournir un mot de code de correction d'erreur pourvu d'une deuxième longueur plus courte que la première longueur et qui n'est pas enregistré dans la sous-matrice, étant configurée pour décoder des données en lecture depuis la matrice de cellules de mémoire codées dans un mot de code de correction d'erreur pourvu de la première longueur, et étant configurée pour décoder des données en lecture depuis la matrice de cellules de mémoire codées dans un mot de code de correction d'erreur pourvu de la deuxième longueur plus courte que la première longueur, et
dans le deuxième mode de correction d'erreur au deuxième niveau de correction d'erreur au deuxième niveau de température de la matrice de cellules de mémoire, la sous-matrice (60b) étant configurée pour être en état de sommeil où son fonctionnement est suspendu ou, à défaut, elle fonctionne avec une alimentation réduite voire sans alimentation.

2. Appareil selon la revendication 1, dans lequel ladite logique de code de correction d'erreur multimode est configurée en outre pour mettre à 1 un drapeau d'état de codage (510c) pour indiquer si les données en écriture associées au drapeau d'état de codage ont été codées au premier niveau de correction d'erreur ou au deuxième niveau de correction d'erreur inférieur au premier niveau de correction d'erreur, et dans lequel ladite logique de code de correction d'erreur multimode est configurée en outre pour adopter le premier mode de correction d'erreur dès lors que le signal de sortie du capteur de température indique que la température de la matrice de cellules de mémoire a dépassé un niveau-seuil et pour balayer la matrice de cellules de mémoire pour détecter si le drapeau d'état de codage a été mis à 1 pour des données en écriture et pour recoder des données en écriture au premier niveau de correction d'erreur en réponse à une détection de la mise à 1 du drapeau d'état de codage pour les données en écriture associées indiquant que les données en écriture associées avaient été codées au deuxième niveau de correction d'erreur.

3. Appareil selon la revendication 2, dans lequel ladite logique de code de correction d'erreur multimode est configurée en outre pour remettre à 0 le drapeau d'état de codage pour des données en écriture recodées au premier niveau de correction d'erreur pour indiquer que les données en écriture associées au drapeau d'état de codage remis à 0 ont été recodées au premier niveau de correction d'erreur supérieur au deuxième niveau de correction d'erreur.

4. Appareil selon la revendication 3, dans lequel la logique de code de correction d'erreur multimode est configurée en outre pour mettre à 1 un drapeau d'état de décodage (510b) pour des données en lecture pour indiquer le niveau de correction d'erreur auquel les données en lecture associées sont susceptibles d'être décodées.

5. Appareil selon la revendication 4, dans lequel ladite logique de code de correction d'erreur multimode est configurée en outre pour :
adopter le deuxième mode de correction d'erreur dès lors que le signal de sortie du capteur de température indique que la température de la matrice de cellules de mémoire est passée en dessous d'un niveau-seuil ;
détecter le drapeau d'état de décodage ;
lire et décoder des données en lecture au deuxième niveau de correction d'erreur en réponse à une détection de la mise à 1 du drapeau d'état de décodage pour les données en lecture associées pour indiquer que les données en lecture sont susceptibles d'être décodées au deuxième niveau de correction d'erreur, et en réponse à une détection de la mise à 1 du drapeau d'état de décodage pour les données en lecture associées pour indiquer que les données en lecture doivent être décodées au premier niveau de correction d'erreur, lire et décoder des données en lecture au premier niveau de correction d'erreur et remettre à 0 le drapeau d'état de décodage pour indiquer que les données en lecture sont susceptibles d'être décodées au deuxième niveau de correction d'erreur.

6. Appareil selon l'une quelconque des revendications 1 à 5, dans lequel la matrice de cellules de mémoire est un cache de mémoire vive à couple de transfert de spin.

7. Appareil selon l'une quelconque des revendications 1 à 6 destiné à être utilisé avec un affichage, comprenant en outre :
une mémoire, la mémoire comportant le circuit de mémoire pourvu de ladite matrice de cellules de mémoire et le contrôleur de mémoire ;
un processeur configuré pour écrire des données et lire des données dans la mémoire ; et
un contrôleur vidéo configuré pour afficher des informations représentées par des données dans la mémoire.

8. Procédé, comprenant :
la détection de la température d'une matrice de cellules de mémoire au moyen d'un capteur de température couplé à la matrice ; et
la réalisation d'un traitement de correction d'erreur de données au moyen d'une logique de code de correction d'erreur multimode, ledit traitement comportant le codage de données en écriture pour la matrice de cellules de mémoire dans un code de correction d'erreur dans l'un d'une pluralité de modes de correction d'erreur en fonction de la température de la matrice de cellules de mémoire,
ledit codage de données en écriture pour la matrice de cellules de mémoire dans un code de correction d'erreur dans l'un d'une pluralité de modes de correction d'erreur comportant le codage de données en écriture dans un premier mode de correction d'erreur à un premier niveau de correction d'erreur à un premier niveau de température de la matrice de cellules de mémoire, et comportant en outre le codage de données en écriture dans un deuxième mode de correction d'erreur à un deuxième niveau de correction d'erreur inférieur au premier niveau de correction d'erreur à un deuxième niveau de température de la matrice de cellules de mémoire inférieur au premier niveau de température de la matrice de cellules de mémoire,
la matrice de cellules de mémoire comportant une sous-matrice, et le codage de données en écriture dans un premier mode de correction d'erreur comportant la fourniture d'un mot de code de correction d'erreur pourvu d'une première longueur et l'enregistrement d'au moins une partie du mot de code de correction d'erreur pourvu de la première longueur dans la sous-matrice de cellules de mémoire, et le codage de données en écriture dans un deuxième mode de correction d'erreur comportant la fourniture d'un mot de code de correction d'erreur pourvu d'une deuxième longueur plus courte que la première longueur, l'enregistrement du mot de code de correction d'erreur pourvu de la deuxième longueur hors de la sous-matrice,
ledit traitement comportant en outre le décodage de données en lecture depuis la matrice de cellules de mémoire codées dans un mot de code de correction d'erreur pourvu de la première longueur, et le décodage de données en lecture depuis la matrice de cellules de mémoire codées dans un mot de code de correction d'erreur pourvu de la deuxième longueur plus courte que la première longueur, et
dans le deuxième mode de correction d'erreur au deuxième niveau de correction d'erreur au deuxième niveau de température de la matrice de cellules de mémoire, la sous-matrice (60b) étant en état de sommeil où son fonctionnement est suspendu ou, à défaut, elle fonctionne avec une alimentation réduite voire sans alimentation.

9. Procédé selon la revendication 8, dans lequel ledit traitement comporte en outre la mise à 1 d'un drapeau d'état de codage (510c) pour indiquer si les données en écriture associées au drapeau d'état de codage ont été codées au premier niveau de correction d'erreur ou au deuxième niveau de correction d'erreur inférieur au premier niveau de correction d'erreur, et comporte en outre l'adoption du premier mode de correction d'erreur dès lors que le capteur de température indique que la température de la matrice de cellules de mémoire a dépassé un niveau-seuil et le balayage de la matrice de cellules de mémoire pour détecter le drapeau d'état de codage et le recodage de données en écriture au premier niveau de correction d'erreur en réponse à une détection du drapeau d'état de codage pour les données en écriture associées indiquant que les données en écriture associées avaient été codées au deuxième niveau de correction d'erreur.

10. Procédé selon la revendication 9, dans lequel le traitement comporte en outre :
la remise à 0 d'un drapeau d'état de codage pour des données en écriture recodées au premier niveau de correction d'erreur pour indiquer que les données en écriture associées au drapeau d'état de codage remis à 0 ont été recodées au premier niveau de correction d'erreur supérieur au deuxième niveau de correction d'erreur ;
la mise à 1 d'un drapeau d'état de décodage pour des données en lecture pour indiquer le niveau de correction d'erreur auquel les données en lecture associées sont susceptibles d'être décodées ;
l'adoption du deuxième mode de correction d'erreur dès lors que le capteur de température indique que la température de la matrice de cellules de mémoire est passée en dessous d'un niveau-seuil ;
la détection du drapeau d'état de décodage ;
la lecture et le décodage de données en lecture au deuxième niveau de correction d'erreur en réponse à une détection du drapeau d'état de décodage indiquant que les données en lecture sont susceptibles d'être décodées au deuxième niveau de correction d'erreur, et en réponse à une détection du drapeau d'état de décodage indiquant que les données en lecture doivent être décodées au premier niveau de correction d'erreur, la lecture et le décodage de données en lecture au premier niveau de correction d'erreur et la remise à 0 du drapeau d'état de décodage pour indiquer que les données en lecture sont susceptibles d'être décodées au deuxième niveau de correction d'erreur ; et
dans lequel la matrice de cellules de mémoire est un cache de mémoire vive à couple de transfert de spin.
